Europäisches Patentamt

European Patent Office

Office européen des brevets

(19)

(11) Publication number: **0 144 741**
**B1**

(12) **EUROPEAN PATENT SPECIFICATION**

(45) Date of publication of patent specification: 02.03.88

(51) Int. Cl.⁴: **C 09 J 3/14,** C 08 K 3/08,
H 01 B 1/22

(21) Application number: 84113218.6

(22) Date of filing: 02.11.84

(54) **Electrically conductive powder for mixing with cyanoacrylates and electrically conductive curable composition containing the same.**

(30) Priority: 04.11.83 JP 205740/83

(43) Date of publication of application:
19.06.85 Bulletin 85/25

(45) Publication of the grant of the patent:
02.03.88 Bulletin 88/09

(84) Designated Contracting States:
DE FR GB IT NL

(56) References cited:
DE-A-2 107 188
FR-A-2 515 196

CHEMICAL ABSTRACTS, vol.85, no.18,
November 1, 1976, Columbus, Ohio, US;
K.INOUE: "Electrically conductive adhesives
containing dendritic metal powders" page 872

The file contains technical information
submitted after the application was filed and
not included in this specification

(73) Proprietor: ATSUGI RESEARCH INSTITUTE CO.,
LTD.
4-12, Nihonbashi 3-chome Chuo-ku
Tokyo (JP)

(72) Inventor: Hara, Junji
595-13, Terabun
Kamakura-shi Kanagawa-ken (JP)

(74) Representative: Strehl, Schübel-Hopf, Groening,
Schulz
Widenmayerstrasse 17 Postfach 22 03 45
D-8000 München 22 (DE)

(56) References cited:
CHEMICAL ABSTRACTS, vol.87, no.20,
November 14, 1977, Columbus, Ohio, US;
K.INOUE: "Adhesives" page 39

Courier Press, Leamington Spa, England.

**Description**

This invention relates to an electrically conductive powder for mixing with cyanoacrylates, and an electrically conductive composition containing this powder and one or more cyanoacrylates as basic components.

Description of the prior art:

Cyanoacrylates rapidly cure at room temperature in contact with materials to be adhered and hence have been widely used as a one-pack, non-solvent type adhesive for adhering plastics, rubbers, ceramics, glass, metals, etc. in various commercial fields.

If an adhesive of the one-pack, non-solvent type, which is curable at room temperature, such as the mentioned cyanoacrylates, could be provided with electric conductivity after being cured, this would be very valuable as an electrically conductive adhesive in the aspect of practical use; thus realization of such an adhesive has been desired.

An electrically conductive adhesive composition containing a dendritic metal powder and a methyl cyanoacrylate-type resin has been known from Chem. Abstracts 85 (1976), 135921b (JP-76/73036). Chem. Abstracts 87 (1977), 153082z (JP-77/74626) further discloses an adhesive composition prepared by mixing metal particles with an insulating binder and a usual adhesive. A representative mixture may comprise powdered Ni, acrylic resin and a cyanoacrylate.

However, mixtures obtained by mixing a highly electrically conductive metal powder with cyanoacrylates have a much inferior storage stability and polymerize rapidly before use. Namely, metal powder has the property of notably inducing cyanoacrylate polymerization and the resulting adhesive composition is unsuitable for practical use; hence a useful storable electrically conductive cyanoacrylate adhesive has never been realized.

In order to remedy these drawbacks, as electrically conductive adhesives mixtures consisting of metal powder and an epoxy resin have usually been often used, but those of the room temperature curing type have a notably inferior storage stability, whereas those with good storage stability type do not cure in a short time unless heated; hence they are practically very inconvenient.

It has already been known that cyanoacrylate adhesive compositions, which do not contain metal powder, may be stabilized by several acidic compounds.

FR—A—2 515 196 describes a stabilized cyanoacrylate adhesive composition which contains a small amount of a stabilizing acid, such as a sulfonic acid, phosphorous acid, phosphonic acid or a carboxylic acid and a dissolved acidic gas, such as $SO_2$.

According to DE—OS 21 07 188 sulfuryl chloride is used as a stabilizer in a cyanoacrylate adhesive composition. The known stabilized compositions, however, do not contain an electrically conductive metal powder. The problem of stabilizing a metal powder containing electrically conductive cyanoacrylate adhesive has therefore not yet been solved. Since furthermore powder metals are highly reactive, it could not be foreseen, whether the stabilization of a metal powder containing composition could be achieved by the substances already known as a stabilizer for cyanoacrylates.

It is therefore the object of the present invention to provide an electrically conductive powder for mixing with cyanoacrylates which, when mixed with cyanoacrylates, does not induce the polymerization of cyanoacrylates and provides the composition with a superior storage stability. It is a further object of the present invention to provide an electrically conductive curable composition on the basis of cyanoacrylates and an electrically conductive metal powder, which shows a superior storage stability and has yet good curability at room temperature and a superior electrical conductivity in the cured state.

According to the present invention it has been found that metal powder which readily induces the polymerization of cyanoacrylates when it is contacted with cyanoacrylates or even cyanoacrylates stabilized in the conventional manner surprisingly does not cause cyanoacrylate polymerization when it has been subjected to a particular treatment. A composition comprising such pre-treated metal powder and cyanoacrylates or cyanocrylates containing a further addition of a polymerization inhibiting substance shows superior storage stability and the resulting cured material has good electrical conductivity.

Subject of the present invention is therefore an electrically conductive powder for mixing with cyanoacrylates, which consists of a metal powder treated with a substance which reacts with water and is at least one compound selected from the group consisting of halides of elements of the groups III to VI of the Periodic Table, elements of the group VII of the Periodic Table and oxygen compounds thereof, oxygen compounds having an acid anhydride group, substances which are readily hydrolyzed to produce acids and metal-containing organic compounds which are readily reactive with water, and/or a substance which acidifies water and is at least one compound selected from the group consisting of acidic compounds, carboxylic acids and halogen acids, each of said acidic compounds containing an element of the groups III, V and VI of the Periodic Table.

A further subject of the present invention is an electrically conductive curable composition comprising as its main components, one or more cyanoacrylates and a metal powder treated with a substance which reacts with water and is at least one compound selected from the group consisting of halides of elements of the groups III to VI of the Periodic Table, elements of the group VII of the Periodic Table and oxygen compounds thereof, oxygen compounds having an acid anhydride group, substances which are readily hydrolyzed to produce acids and metal-containing organic compounds which are readily reactive with water, and/or a substance which acidifies water and is at least one compound selected from the group consisting of acidic compounds, carboxylic acids and halogen acids, each of said acidic compounds containing an element of the groups III, V and VI of the Periodic Table.

In the following description the substance used for the treatment of the metal powder will be referred to as cyanoacrylate polymerization inhibiting substance.

According to one embodiment of the present invention the above cyanoacrylate polymerization-inhibiting substance is further added as an independent component to the electrically conductive composition which comprises the electrically conductive powder treated with the stated substance.

The form of the metal powder used in the present invention has no particular limitation. For example, those in various forms such as flaky, particulate or dendritic form may be used alone or in admixture.

As the metal forming the metal powder, metals having electrical conductivity, such as gold, platinum, iridium, paladium, silver, chromium, nickel, etc. and besides, various alloys of two or more components such as Ag-Cu alloy, brass, bronze, stainless steel, etc. may be used. Further, a metal powder having a multi-layer structure such as that having copper at the central part and silver at the surface part may also be used, further, e.g. a powder having a substance other than metal such as glass, mica, high molecular weight polymers, etc. at the central part and a metal coating the surface part may also be used as the metal powder in the present invention.

As to the substance for preventing or inhibiting the property of metal powder of inducing cyanoacrylate polymerization by its reaction with water (hereinafter referred to as reactive, polymerization-inhibiting substance), used as one of the cyanoacrylate polymerization-inhibiting substances in the present invention, its representative examples are halides of elements of the group III of the Periodic Table, such as boron trichloride, boron tribromide, etc., phosgene, acetyl chloride, benzoyl bromide, acryloyl chloride, isophthaloyl dichloride, polymethacryloyl chloride, cyanuric chloride, chloroisopropyl carbonate, halides of elements of the group IV of the Periodic Table such as silicon tetrachloride, trichlorosilane, trimethylchlorosilane, vinyltrichlorosilane, diphenyldichlorosilane, titanium germanium tetrachloride, etc., nitrosyl chloride, halides of elements of the group V of the Periodic Table such as phosphorous trichloride, phosphorous tribromide, phosphorous triiodide, phosphorous pentachloride, phosphorous oxychloride, phenylphosphorous dichloride, dibutylphosphorous chloride, bisphenoxyphosphorous monobromide, phenylphosphonic acid dichloride, antimony pentachloride, vanadium tetrachloride, etc., halides of elements of the group VI of the Periodic Table such as sulfur chloride, thionyl chloride, sulfuryl chloride, pyrosulfuryl chloride, chlorosulfonic acid, toluenesulfonyl chloride, benzenedisulfonyl chloride, selenium tetrachloride, chromyl chloride, etc., simple substances, i.e. elements of the group VII of the Periodic Table or their oxygen compounds such as chlorine, bromine, chlorine hexoxide, etc., various oxygen compounds having an anhydrous acid structure in the broad sense such as acetic anhydride, ketene, diketene, benzoic anhydride, polysebacic anhydride, maleic anhydride, nitrogen dioxide, phosphorous pentoxide, polyphosphoric acid, sulfur trioxide, sulfur dioxide, fuming sulfuric acid, etc., substances which are readily hydrolyzed to produce acids such as dimethyl sulfate, methyl toluenesulfonate, pentaerythritolbisoctyl phosphite, etc., and metal-containing organic compounds which are readily reactive with water such as triethylaluminum, ethylaluminum dichloride, diisobutylaluminum hydride, ethylmagnesium bromide, aluminum triisopropoxide, etc., and among these, substances which produce acids by the reaction with water are particularly preferable. Of course, it is also possible to use two or more of these compounds at the same time.

Further, as to the substance for preventing or inhibiting the property of metal powder of inducing cyanoacrylate polymerization (such substance will hereinafter be referred to as acidic, polymerization-inhibiting substance), used as one of the cyanoacrylate polymerization-inhibiting substances, its representative examples are acidic substances containing elements of the group III of the Periodic Table, such as boron trifluoride, aluminum chloride, etc., acidic substances containing elements of the group V of the Periodic Table, such as nitric acid, phosphorus acid, phosphoric acid, mono-n-propyl phosphate, dibutyl phosphate, phenyl phosphonic acid, antimony pentafluoride, niobium pentafluoride, tantalum pentafluoride, etc., acidic substances containing elements of the group VI of the Periodic Table, such as toluenesulfonic acid, dodecylbenzenesulfonic acid, benzenesulfinic acid, fluorosulfonic acid, etc., carboxylic acids, preferably those having a pKa value of 3.5 or less, such as trichloroacetic acid, trifluoroacetic acid, dinitrobenzoic acid, etc., halogen acids such as hydrogen fluoride, hydrogen chloride, hydrogen bromide, chloric acid, periodic acid, etc., and of course, two or more of these compounds may be used at the same time.

Further, the reactive, polymerization-inhibiting substances and the acidic, polymerization-inhibiting substances may be used alone or at the same time. The treatment of metal powder with the polymerization-inhibiting substances is preferably carried out usually by making metal powder present in gas phase or liquid phase containing the polymerization-inhibiting substances and treat it with stirring or without stirring. In this case, a solvent may be used, and the temperature employed is preferably room temperature or a higher temperature. In addition, metal powder is preferably heated under reduced pressure or dried under low humidity in advance of treating the powder with the polymerization-inhibiting substances.

The amount of the polymerization-inhibiting substances used for treating metal powder in the present invention varies depending on the kind of metal powder, the kind of the polymerization-inhibiting substances and the manner of treating the powder with the substances, but the amount is usually in the range of 0.01 to 50 parts by weight, preferably 0.1 to 10 parts by weight, based on 100 parts by weight of metal powder, in the case of the reactive, polymerization-inhibiting substances. Further, it is usually in the range of 0.01 to 50 parts by weight, preferably 0.07 to 10 parts by weight, in the case of the acidic, polymerization-inhibiting substances.

Naturally, it is desirable that the metal powder used in the present invention is dried before or/and after treating as above.

In the present invention, the temperature at which metal powder is dried or placed under reduced pressure has no particular limitation in a range from freezing point to high temperatures, but such high temperatures as deform the shape of metal powder used are of course undesirable.

In the present invention, as to the manner in which the dried atmosphere is prepared, its representative examples are a manner wherein a drying agent is placed in an adequate closed vessel, followed by still standing, and a manner employing a system in which a dry inert gas such as nitrogen, helium, argon, etc. flows continuously. Of course, drying under reduced pressure may be employed. As the drying agent, any of those of a type reacting with water, a type absorbing water and a type adsorbing water may be employed, and any of acidic, neutral and alkaline agents may also be employed. Its representative examples are silica gel, calcium chloride, conc. sulfuric acid, metal sodium, slaked lime, calcium hydride and reactive, polymerization-inhibiting substances described later, and they are not added to metal powder, but placed in the same atmosphere as that in which metal powder is placed, and used.

In the present invention, when metal powder is dried or treated under reduced pressure, it may be held in any state of dynamic states such as stirring, vibration, etc. The metal powder for mixing with cyanoacrylates, obtained according to the present invention, is preferably placed in a dry atmosphere during the preiod till it is mixed with cyanoacrylates, i.e. during its storage, transportation, weighing, etc.

The reduced pressure employed in the present invention has no particular limitation, but it refers usually to 4000 Pa (30 mmHg) or less, preferably 1333 Pa (10 mmHg) or less.

Cyanoacrylates used in the present invention include all of various esters of 2-cyanoacrylic acid. Their concrete examples are methyl, ethyl, n-propyl, isopropyl, n-butyl, sec-butyl, t-butyl, amyl, n-hexyl, cyclohexyl, dodecyl, allyl, propargyl, allylbenzyl, phenyl, 2-chloroethyl, 2-cyanoethyl, pentafluoroethyl, etc. 2-cyanoacrylates, and two or more kinds of these may be also used at the same time.

The reactive, polymerization-inhibiting substances and the acidic, polymerization-inhibiting substances added to cyanoacrylates consist of one or more kinds of substances described before which react with water or/and acidify water. These polymerization-inhibiting substances are added either before, at the same time when or after metal powder for mixing with cyanoacrylates is mixed with cyanoacrylates.

The amount of the polymerization-inhibiting substances added to cyanoacrylates is usually in the range of 10 ppm to 20,000 ppm, preferably 30 ppm to 1,000 ppm based on the weight of cyanoacrylates.

Cyanoacrylates are preferably dehydrated in advance under reduced pressure or by drying. This is due to the fact that when metal powder treated with the polymerization-inhibiting substances is used, the water content in cyanoacrylates has a larger influence as compared with conventional cyanoacrylate adhesives having no electrical conductivity so that cyanoacrylates are liable to polymerize at the time of storage.

The amount of cyanoacrylates used based on 100 parts by weight of electrically conductive powder for mixing with cyanoacrylates in the present invention is usually in the range of 10 to 150 parts by weight, preferably 25 to 100 parts by weight. To a mixture of the electrically conductive powder with cyanoacrylates or cyanoacrylates having the polymerization-inhibiting substances added may be added a substance which assists in preventing or inhibiting the property of metal powder of inducing cyanoacrylate polymerization, such as a substance having hydroxyl group or thiol group e.g. monohydric or polyhydric alcohols, phenols, thiols, etc., and further known additives for cyanoacrylates such as radical polymerization inhibitors, various adhesion-enhancing substances such as acrylic copolymer rubber, solvents such as chloroform for viscosity adjustment, plasticizers such as dimethyl sebacate, thickening agents such as polymethyl methacrylate, cross-linking agents such as allyl cyanoacrylate, dyestuffs, etc. may be added in a suitable amount, if necessary.

In order to cure the electrically conductive composition of the present invention in seconds, the curing accelerator comprising amine(s) solution can be used onto the droplet of the mixed composition on a surface of a substrate.

The electrically conductive, curable composition of the present invention may be used for various applications, such as adhesives requiring electrical conductivity, applied for the adhesion of plastics, rubbers, ceramics, etc., concretely, for example, adhesion for caulking reinforcement and contact stabilization of eyelet or screw part, ceramics and metals, taking out of leads of quartz crystal oscillator, flash, cadmium sulfide meter, etc., carbon brush of motor, LED element to base, and semiconductor element of die bonding to electrode. Further there are use applications other than adhesives, e.g. for filling narrow clearances, molding electrically conductive thin films, etc.

Example 1

A purified flaky silver powder (5 g) was added to each of the solutions of various reactive, polymerization-inhibiting substances (0.2 g) shown in Table 1 dissolved in acetone (25 g) and the mixture was agitated for 30 minutes, followed by filtering off the silver powder from the solution and drying the silver powder at 60°C for 5 hours. The thus prepared silver powder (100 parts by weight) was mixed with ethyl 2-cyanoacrylate (50 parts by weight) and the mixture was preserved in a polyethylene vessel at 20°C and a relative humidity of 60%. Further, as in the case of conventional cyanoacrylate adhesives, to the mixed solution were added $SO_2$ (50 ppm) and hydroquinone (200 ppm) as stabilizers. After one hour, the respective solutions were adhered and cured. And their viscosity, setting time, volume resistivity and tensile shear strength were respectively measured. The viscosity measurement was carried out by means of a rotational viscometer (B type viscometer). As to the setting time, one drop of the mixed liquid prepared above was attached onto only the surface to be adhered of one of a pair of steel test pieces (surface to be adhered: $0.875$ cm$^2$), these pieces were placed on one another, a load of 5.0 kg/cm$^2$ was acted perpendicularly onto the adhered surface and a period of time till a generated strength by which the load was lifted was measured. The volume resistivity was measured according to JIS K-6911. The tensile shear strength was measured according to JIS K-6850, using steel test pieces (dimension: 100mm×25 mm×1.6 mm). The experimental results are shown in Table 1.

TABLE 1

| Reactive, polymerization-inhibiting substance | Measurement item | | | |
|---|---|---|---|---|
| | Viscosity Pa · s (CPS) | Setting time (sec) | Volume resistivity (×10$^{-4}$Ω-cm) | Tensile shear strength (kg/cm$^2$) |
| (1) Boron trichloride | 0.60 (600) | 600 | 5.5 | 70 |
| (2) Acetyl chloride | 0.50 (500) | 500 | 7.0 | 60 |
| (3) Trimethylchlorosilane | 0.55 (550) | 600 | 5.0 | 80 |
| (4) Phosphorous oxychloride | 0.45 (450) | 420 | 6.5 | 50 |
| (5) Thionyl chloride | 0.35 (350) | 300 | 4.8 | 40 |
| (6) Chlorine hexoxide | 0.30 (300) | 240 | 5.0 | 80 |
| (7) Acetic anhydride | 0.40 (400) | 300 | 5.8 | 40 |
| (8) Ethylaluminum dichloride | 0.45 (450) | 400 | 5.0 | 70 |

In addition, when non-treated silver powder was mixed with ethyl 2-cyanoacrylate, the latter polymerized within 20 seconds.

Example 2

A purified flaky silver powder (5 g) was added into acetone (25 g) and the mixture was agitated for 30 minutes. Further, each of various acidic, polymerization-inhibiting substances (0.5 g) was dissolved in the solution, followed by stirring for 2 hours, then filtering off the silver powder from the solution, drying the resulting silver powder at 60°C for 5 hours, mixing the silver powder (100 parts by weight) thus prepared with ethyl 2-cyanoacrylate (66 parts by weight), and preserving the mixture in a polyethylene vessel at 20°C and a relative humidity of 60%. After one hour, the respective mixed solutions were adhered and cured. And their viscosity, setting time, volume resistivity and tensile shear strength were respectively measured. The measurement methods were the same as those in Example 1.

TABLE 2

| Acidic, polymerization-inhibiting substance | Measurement item | | | |
|---|---|---|---|---|
| | Viscosity Pa · s (CPS) | Setting time (sec) | Volume resistivity ($\times 10^{-4}\Omega$-cm) | Tensile shear strength (kg/cm$^2$) |
| (1) Aluminum chloride | 0.38 (380) | 300 | 6.5 | 80 |
| (2) Nitric acid | 0.36 (360) | 300 | 6.0 | 75 |
| (3) Dodecylbenzene-sulfonic acid | 0.90 (900) | about 30 min. | 7.5 | 65 |
| (4) Trifluoroacetic acid | 0.40 (400) | 360 | 4.8 | 85 |
| (5) Hydrogen fluoride | 0.35 (350) | 300 | 5.5 | 90 |
| (6) Dibutylphosphoric acid | 0.35 (350) | 300 | 6.0 | 80 |

Example 3

Phenylphosphonic acid (0.5 g) was dissolvdd in acetone (25 g), and a purified flaky silver powder (5 g) was added, followed by stirring for 2 hours, then filtering off the silver powder from the solution, drying the resulting silver powder at 60°C for 5 hours, mixing the thus prepared silver powder (100 parts by weight) with ethyl 2-cyanoacrylate (66 parts by weight) having various reactive, polymerization-inhibiting substances (200 ppm) dissolved therein in advance and preserving the mixture in a polyethylene vessel at 20°C and a relative humidity of 60%. In addition, chloroform (10 parts by weight) was added. After two hours, the respective mixed solutions were adhered and cured, and their viscosity, setting time, volume resistivity and tensile shear strength were measured. The measurement methods were the same as those in Example 1.

TABLE 3

| Reactive, polymerization-inhibiting substance | Measurement item | | | |
|---|---|---|---|---|
| | Viscosity Pa · s (CPS) | Setting time (sec) | Volume resistivity ($\times 10^{-4}\Omega$-cm) | Tensile shear strength (kg/cm$^2$) |
| (1) Boron trichloride | 0.30 (300) | 210 | 8.5 | 90 |
| (2) Acetyl chloride | 0.20 (200) | 180 | 8.8 | 80 |
| (3) Trimethylchlorosilane | 0.35 (350) | 240 | 6.0 | 75 |
| (4) Phosphorous oxychloride | 0.25 (250) | 180 | 8.0 | 80 |
| (5) Thionyl chloride | 0.24 (240) | 180 | 9.8 | 90 |
| (6) Chlorine hexoxide | 0.40 (400) | 300 | 8.5 | 70 |
| (7) Acetic anhydride | 0.25 (250) | 180 | 9.0 | 80 |
| (8) Ethylaluminum dichloride | 0.35 (350) | 240 | 6.0 | 60 |

Example 4

Thionyl chloride (0.2 g) was dissolved in acetone (25 g), and to this solution was added a silver powder (5 g) obtained by drying in vacuo for one hour under conditions of a degree of vacuum of 1333 Pa (10 mmHg) and a temperature of 60°C, followed by stirring for 30 minutes, further dissolving phenylphosphonic acid (0.5 g) and mono-n-propyl phosphate (0.2 g) in the solution, mixing them with stirring for 2 hours, then filtering off the silver powder from the solution, drying in vacuo the resulting silver powder at a degree of vacuum of 1333 Pa and a temperature of 60°C for one hour, mixing the thus prepared silver powder (100 parts by weight) with ethyl 2-cyanoacrylate (66 parts by weight) having various acidic, polymerization-inhibiting substances (100 ppm) dissolved therein in advance and preserving the mixture in a polyethylene vessel at 20°C and a relative humidity of 60%. After five hours, the respective mixed solutions were adhered and cured, and their viscosity, setting time, volume resistivity and tensile shear strength were measured. The measurement methods were the same as those in Example 1.

TABLE 4

| Acidic, polymerization-inhibiting substance | Measurement item | | | |
| --- | --- | --- | --- | --- |
| | Viscosity Pa·s (CPS) | Setting time (sec) | Volume resistivity ($\times 10^{-4}$ Ω-cm) | Tensile shear strength (kg/cm²) |
| (1) Aluminum chloride | 0.38 (380) | 300 | 8.5 | 70 |
| (2) Nitric acid | 0.40 (400) | 300 | 5.5 | 60 |
| (3) Dodecylbenzene-sulfonic acid | 0.30 (300) | 240 | 8.0 | 80 |
| (4) Trifluoroacetic acid | 0.25 (250) | 210 | 8.0 | 90 |
| (5) Hydrogen fluoride | 0.28 (280) | 210 | 9.0 | 90 |

Example 5

A purified flaky silver powder (5 g) were dried in vacuo for one hour under conditions of a degree of vacuum of 1333 Pa (10 mmHg) and a temperature of 60°C, followed by adding the powder to a solution of phosphorous oxychloride (0.1 g) dissolved in acetone (25 g), followed by further dissolving phenylphosphonic acid (0.5 g) in the solution, mixing by stirring for 2 hours, then filtering off the silver powder from the solution, drying in vacuo the resulting silver powder for 2 hours at a degree of vacuum of 1333 Pa (10 mmHg) and a temperature of 60°C. The thus prepared silver powder (100 parts by weight) was mixed with ethyl 2-cyanoacrylate or methyl 2-cyanoacrylate (66 parts by weight) having phosphorous oxychloride (100 ppm) dissolved therein in advance and the mixture was preserved in a polyethylene vessel at 20°C and a relative humidity of 60%. After the respective hour(s) indicated in the following Table, the respective solutions were adhered and cured and their viscosity, setting time, volume resistivity and tensile shear strength were measured. The meusurement methods were the same as those in Example 1.

TABLE 5

| Cyanoacrylate | Measurement item / Lapse hour(s) | one hour | 3 hours | 5 hours |
|---|---|---|---|---|
| (1) Ethyl 2-cyanoacrylate | Viscosity, Pa · s (CPS) | 0.25 (250) | 0.30 (300) | 0.50 (500) |
| | Setting time (sec) | 240 | 300 | 1,000 |
| | Volume resistivity ($\times 10^{-4}\Omega$-cm) | 3.5 | 3.8 | 4.0 |
| | Tensile shear strength (kg/cm$^2$) | 80 | 80 | 70 |
| (2) Methyl 2-cyanoacrylate | Viscosity, Pa · s (CPS) | 0.25 (250) | 0.35 (350) | 0.60 (600) |
| | Setting time (sec) | 240 | 300 | 1,200 |
| | Volume resistivity ($\times 10^{-4}\Omega$-cm) | 4.0 | 4.0 | 4.5 |
| | Tensile shear strength (kg/cm$^2$) | 100 | 90 | 90 |

In addition, when non-treated silver powder was added to these cyanoacrylates, the resulting solutions polymerized in about 3 minutes so that the measurement was impossible.

Example 6

Various purified metal powders were dried in vacuo for one hour under conditions of 60°C and a degree of vacuum of 1333 Pa (10 mmHg), followed by adding each of the metal powder (5 g) to a solution of sulfuryl chloride (0.25 g) dissolved in acetone (25 g), stirring for 30 minutes, further dissolving phenylphosphonic acid (0.5 g) in the solution, mixing the mixture with stirring for 2 hours, then filtering off the metal powder from the solution, drying in vacuo the resulting metal powder at a degree of vacuum of 1333 Pa (10 mmHg) and 60°C for 2 hours, mixing the thus prepared metal powder (100 parts by weight) with ethyl 2-cyanoacrylate (66 parts by weight) having sulfuryl chloride (100 ppm) dissolved therein in advance and preserving the mixture in a polyethylene vessel at 20°C and a relative humidity of 60%. After one hour, the resulting mixed solutions were adhered and cured, and their viscosity, setting time, volume viscosity and tensile shear strength were measured. The measurement methods were the same as those in Example 1.

TABLE 6

| Metal powder | Measurement item | | | |
|---|---|---|---|---|
| | Viscosity Pa · s (CPS) | Setting time (sec) | Volume resistivity ($\times 10^{-4}\Omega$-cm) | Tensile shear strength (kg/cm$^2$) |
| (1) Gold | 0.30 (300) | 300 | 2.5 | 70 |
| (2) Platinum | 0.35 (350) | 360 | 12.5 | 75 |
| (3) Paladium | 0.32 (320) | 360 | 14.0 | 65 |

8

# 0 144 741

**Claims**

1. An electrically conductive powder for mixing with cyanoacrylates, which consists of a metal powder treated with a substance which reacts with water and is at least one compound selected from the group consisting of halides of elements of the groups III to VI of the Periodic Table, elements of the group VII of the Periodic Table and oxygen compounds thereof, oxygen compounds having an acid anhydride group, substances which are readily hydrolyzed to produce acids and metal-containing organic compounds which are readily reactive with water, and/or a substance which acidifies water and is at least one compound selected from the group consisting of acidic compounds, carboxylic acids and halogen acids, each of said acidic compounds containing an element of the groups III, V and VI of the Periodic Table.

2. An electrically conductive, curable composition comprising as its main components, one or more cyanoacrylates and a metal powder treated with a substance which reacts with water and is at least one compound selected from the group consisting of halides of elements of the groups III to VI of the Periodic Table, elements of the group VII of the Periodic Table and oxygen compounds thereof, oxygen compounds having an acid anhydride group, substances which are readily hydrolyzed to produce acids and metal-containing organic compounds which are readily reactive with water, and/or a substance which acidifies water and is at least one compound selected from the group consisting of acidic compounds, carboxylic acids and halogen acids, each of said acidic compounds containing an element of the groups III, V and VI of the Periodic Table.

3. An electrically conductive, curable composition according to claim 2, further comprising a substance which reacts with water and is at least one compound selected from the group consisting of halides of elements of the groups III to VI of the Periodic Table, elements of the group VII of the Periodic Table and oxygen compounds thereof, oxygen compounds having an acid anhydride group, substances which are readily hydrolyzed to produce acids and metal-containing organic compounds which are readily reactive with water, or a substance which acidifies water and is at least one compound selected from the group consisting of acidic compounds, carboxylic acids and halogen acids, each of said acidic compounds containing an element of the groups III, V and VI of the Periodic Table.

**Patentansprüche**

1. Elektrisch leitendes Pulver zum Vermischen mit Cyanacrylaten, bestehend aus einem Metallpulver, welches mit einer Substanz, die mit Wasser reagiert und mindestens eine Verbindung darstellt, die aus der aus Halogeniden von Elementen der Gruppen III bis VI des Periodensystems, Elementen der Gruppe VII des Periodensystems und deren Sauerstoffverbindungen, Sauerstoffverbindungen mit einer Säureanhydridgruppe, Substanzen, die leicht unter Bildung von Säuren hydrolysiert werden und Metall enthaltenden organischen Verbindungen, die gegenüber Wasser leicht reaktiv sind, bestehenden Gruppe ausgewählt ist, und/oder einer Substanz behandelt wurde, die Wasser ansäuert und mindestens eine Verbindung darstellt, die aus der aus sauren Verbindungen, Carbonsäuren und Halogensäuren bestehenden Gruppe ausgewählt ist, wobei jede dieser sauren Verbindungen ein Element der Gruppen III, V und VI des Periodiensystems enthält.

2. Elektrisch leitende härtbare Zusammensetzung, die als Hauptkomponenten ein oder mehrere Cyanacrylate und ein Metallpulver enthält, welches mit einer Substanz, die mit Wasser reagiert und mindestens eine Verbindung darstellt, die aus der aus Halogeniden von Elementen der Gruppen III bis VI des Periodensystems, Elementen der Gruppe VII des Periodensystems und deren Sauerstoffverbindungen, Sauerstoffverbindungen mit einer Säureanhydridgruppe, Substanzen, die leicht unter Bildung von Säuren hydrolysiert werden und Metall enthaltenden organischen Verbindungen, die gegenüber Wasser leicht reaktiv sind, bestehenden Gruppe ausgewählt ist, und/oder einer Substanz behandelt wurde, die Wasser ansäuert und mindestens eine Verbindung darstellt, die aus der aus sauren Verbindungen, Carbonsäuren und Halogensäuren bestehenden Gruppe ausgewählt ist, wobei jede dieser sauren Verbindungen ein Element der Gruppen III, V und VI des Periodensystems enthält.

3. Elektrisch leitende härtbare Zusammensetzung gemäß Anspruch 2, die außerdem eine Substanz enthält, welche mit Wasser reagiert und mindestens eine Verbindung darstellt, die aus der aus Halogeniden von Elementen der Gruppen III bis VI des Perioden-systems, Elementen der Gruppe VII des Periodensystems und deren Sauerstoffverbindungen, Sauerstoffverbindungen mit einer Säureanhydridgruppe, Substanzen, die leicht unter Bildung von Säuren hydrolysieren und Metall enthaltenden organischen Verbindungen, die gegenüber Wasser leicht reaktiv sind, bestehenden Gruppe gewählt ist oder eine Sustanz enthält, die Wasser ansäuert und mindestens eine Verbindung ist, die aus der Gruppe der sauren Verbindungen, Carbonsäuren und Halogensäuren ausgewählt ist, wobei jede dieser sauren Verbindungen ein Element der Gruppen III, V und VI des Periodensystems enthält.

**Revendications**

1. Une poudre électroconductrice à mélanger des cyanoacrylates, qui consiste en une poudre métallique traitée par une substance qui réagit avec l'eau et qui est au moins un composé choisi parmi les

**0 144 741**

halogénures des éléments des groupes III à VI de la classification périodique, les éléments du groupe VII de la classification périodique et leurs composés oxygénés, les composés oxygénés ayant un groupe anhydride d'acide, les substances qui sont facilement hydrolysées pour donner des acides et les composés organiques contenant un métal qui réagissent facilement avec l'eau et/ou une substance qui acidifie l'eau et qui est au moins un composé choisi parmi les composés acides, les acides carboxyliques et les acides halogénés, chacun desdits composés acides contenant un élément des groupes III, V et VI de la classification périodique.

2. Une composition durcissable électroconductrice comprenant comme composants principaux un ou plusieurs cyanoacrylates et une poudre métallique traitée par une substance qui réagit avec l'eau et qui est au moins un composé choisi parmi les halogénures des éléments des groupes III à VI de la classification périodique, les éléments du groupe VII de la classification périodique et leurs composés oxygénés, les composés oxygénés ayant une groupe anhydride d'acide, les substances qui sont facilement hydrolysées pour produire des acides et les composés organiques contenant un métal qui réagissent facilement avec l'eau et/ou une substance qui acidifie l'eau et qui est au moins un composé choisi parmi les composés acides, les acides carboxyliques et les acides halogénés, chacun desdits composés acides contenant un élément des groupes III, V et VI de la classification.

3. Une composition durcissable électroconductrice selon la revendication 2, comprenant en outre une substance qui réagit avec l'eau et qui est au moins un composé choisi parmi les halogénures des éléments des groupes III à VI de la classification périodique, les éléments du groupe VII de la classification périodique et leurs composés oxygénés, les composés oxygénés ayant un groupe anhydride d'acide, les substances qui sont facilement hydrolysées pour produire des acides et les composés organiques contenant un métal qui réagissent facilement avec l'eau, ou une substance qui acidifie l'eau et qui est au moins un composé choisi parmi les composés acides, les acides carboxyliques et les acides halogénés, chacun desdits composés acides contenant un élément des groupes III, V et VI de la classification périodique.